# EUROPEAN PATENT SPECIFICATION

(11) **EP 0 573 270 B1**
(45) Date of publication and mention of the grant of the patent: **26.08.1998**
(21) Application number: 93304262.4
(22) Date of filing: 02.06.1993
(51) Int. Cl.: H01L 21/205, H01L 21/306

(54) **Method of preparing compound semiconductor**
Herstellungsverfahren von Verbindungshalbleitern
Procédé de fabrication d'un semi-conducteur composé

(30) Priority: 02.06.1992 JP 141807/92
(43) Date of publication of application: 08.12.1993
(73) Proprietor: Mitsubishi Chemical Corporation, Chiyoda-ku Tokyo (JP)
(72) Inventor: Goto, Hideki, Tsuchiura-city, Ibaraki (JP); Shimoyama, Kenji, Tsuchiura-city, Ibaraki (JP)
(74) Representative: Paget, Hugh Charles Edward

(56) References cited:
- US-A- 4 671 847
- US-A- 5 068 007
- PATENT ABSTRACTS OF JAPAN vol. 013, no. 056 (C-566)8 February 1989 & JP-A-63 248 796 (NEC CORP.) 17 October 1988
- PATENT ABSTRACTS OF JAPAN vol. 5, no. 133 (E-71)(805) 25 August 1981 & JP-A-56 070 630 (MITSUBISHI MONSANTO KASEI K.K.) 12 June 1981
- JOURNAL OF CRYSTAL GROWTH vol. 109, no. 1/4 , February 1991 , AMSTERDAM NL pages 264 - 271 J.L.ZILKO ET AL. 'EFFECT OF MESA SHAPE ON THE PLANARITY OF INP REGROWTHS PERFORMED BY ATMOSPHERIC PRESSURE AND LOW PRESSURE SELECTIVE METALORGANIC VAPOR PHASE EPITAXY'

## Description

The present invention relates to a method of preparing a compound semiconductor having a carrier-injection layer or an electrode-drawing layer, which is formed by a crystal regrowth method or a selective growth method.

For the purpose of improving the performance of a compound semiconductor device, the structure suitable for the shortening of a channel has been investigated in an electron device, and also the side-joint structure for the OEIC (Optoelectronic Integrated Circuit) has been investigated in a semiconductor laser. As an effective method to realise these structures, a self-alignment method of forming a carrier-injection layer or an electrode-drawing layer, by a regrowth of a selective growth methods, has been generally used.

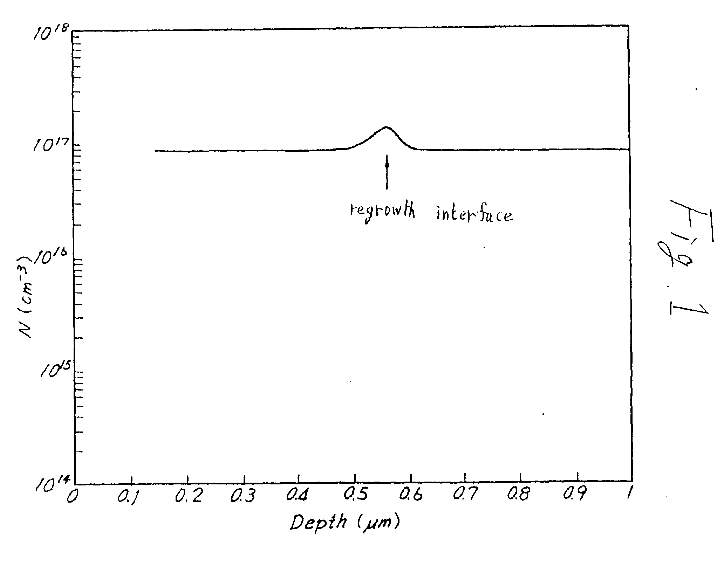

In such a case, the surface of a substrate or an epitaxial growth layer is subjected to an impurity pollution or a physical damage, during the processes of exposure in the air, etching, washing and the like. Then, if a regrowth is directly effected on these surfaces as they are, the performance or the life time of a device will be exceedingly deteriorated. For that reason, the cleaning of the surface and the removal of the damaged layer have been executed in a growth chamber by a vapor phase etching method, immediately followed by effecting the regrowth procedure. The compound semiconductor device prepared by such a method, however, poses a problem that the carriers will be accumulated on the regrowth surface as shown in Fig. 1, though the purity of the surface will be improved.

US-A-4 671 847 describes a method of improving surface morphology, in growth of air InP or InGa As epilayer, by etching the surface prior to the growth with vapour from liquid ethylene dibromide. Phosphine is included in the etching atmosphere to inhibit InP thermo decomposition.

The object of the present invention is to overcome or reduce the above problem.

Firstly, the inventors assumed that in case of a usual compound semiconductor, for example, the group III-V compound semiconductor, the chlorides of group III and group V elements would be formed on the surface by introducing, for example, a chlorine-series etching gas, and the etching would be followed by evaporation of these chlorides into a vapor phase, and then, a stoichiometric discrepancy between group III and group V would occur on the gas-etched surface, thereby bringing about a carrier accumulation in the crystal regrowth interface.

Secondly, the inventors found that a plain profile without carrier accumulation on the regrowth interface could be obtained, by passing hydrides containing group III organic metals gas and/or group V elements, or the group V organic metals gas during the gas-etching, in order to prevent the carrier accumulation.

Accordingly, the present invention can provide a method of preparing a semiconductor device, which gives at the same time both improved purity of the regrowth interface and stabilisation of the carrier concentration.

In accordance with the present invention there is provided a method of preparing a group III-V compound semiconductor thin film, as set out in claim 1.

Also, preferably in the above method of preparing a compound semiconductor crystal, a compound semiconductor thin-film is allowed to be regrown or selectively grown, on a mesa-shape substrate or an epitaxial layer formed by a gas-etching in the growth chamber. Further preferably in the above method of preparing a compound semiconductor crystal and in the compound semiconductor obtained thereby, a gas containing one or more halogen elements is used, as the gas used in the vapor phase etching.

The present invention will be explained in detail below. The group III-V compound semiconductors to be used in the present invention are not specifically limited, as these are conventionally used as semiconductor devices, and GaAs, GaAlAs, InP, InAsP, InGaAsP and the like are specifically given as examples. The hydrides and the organometallic gas are not also particularly limited, and these may be selected from those with which a desired compound semiconductor will be obtained. For example, in case of GaAs, arsine (AsH₃) or phosphine (PH₃) are used as the hydride, and trimethyl gallium (TMG), triethyl gallium (TEG), trimethyl aluminum (TMA), triethyl aluminum (TEA), trimethyl indium (TMI) and the like are preferably used as the organometallic gas.

In accordance with the present invention, it is featured that the hydrides containing group III organic metals gas and/or group V elements, or the group V organic metals gas will be passed concurrently with a carrier gas and an etching gas, at the time the etching for the cleaning of growth surface is effected in a growth chamber, immediately before the vapor phase growth of the compound semiconductor thin film, using the aforementioned hydrides and organometallic gases. The organometallic gas and/or the hydride used at this time are not specially limited, but may generally contain the group III and/or the group V elements composing the compound to be grown by a vapor phase growth method.

In the invention, especially in case of doping immediately after the gas-etching, an organometallic gas of a group III metal will be introduced, when a dopant to enter the group III site is employed, and also a hydride containing a group V element or an organometallic gas of a group V metal will be introduced, when dopants to enter the group V site are employed. By this operation, the accumulation of dopant at the regrowth interface will be decreased. For instance, in case of the silicon doping, the group III metal organometallic gas is preferably used and TMG or TEG is for example used. In case of the selenium doping, a group V element hydride of the group V metal organometallic gas are preferably used and arsine is for example used.

The carrier gas is not especially limited and conventionally used gases may be employed, and hydrogen is an example. Also, the etching gas is not limited, and conventional etching gases may be used. A gas containing one or more halogen elements is preferable, a chlorine series reactive gas is more preferable, and at least one of HCl, CCl₂F₂, AsCl₃ and Cl₂ is most preferable.

The etching condition is not limited, but 500°C-800°C of temperature is usually used so as to enhance etching speed. The introduced amount of the etching gas and the organometallic gas varies to a great extent, according to the size of growth chamber and the performance of desired semiconductor device and in general more etching gas then the organometallic gas will be introduced. Also, since the etching speed will be lowered with reduction of a temperature, the amount of the etching gas may be increased in the case of low temperature. The total pressure of the gas to be passed is preferably at atmospheric or reduced pressure.

Features and advantages obtainable with the present invention will become more apparent, from the following description of an embodiment taken in conjunction with the accompanying drawings, in which:-
Fig. 1 is a carrier-concentration profile around the regrowth interface, in a case where TMG was not introduced together with an etching gas during a vapor etching process.
Fig. 2 is a carrier-concentration profile around the regrowth interface, in a case where TMG was introduced together with an etching gas during a vapor etching process.
Fig. 3 is a carrier-concentration profile around the regrowth interface, in a case where the regrowth was effected without an etching operation after an exposure to atmosphere.
Fig. 4 is a result of the SIMS (Secondary Ion Mass Spectrometer) analysis, in a case where the regrowth was effected without etching after an exposure to atmosphere.
Fig. 5 is a result of the SIMS analysis, in a case where a gas etching operation was effected after an exposure to atmosphere, and then the regrowth was executed.

### Example:

In this Example, as raw materials, where the growth is effected using a Metal-Organic Vapor Phase Epitaxial growth (hereinafter referred to as MOVPE) method TMG (trimethyl gallium) and AsH₃ (arsine) were used, and as an etching gas, HCl (hydrogen chloride) was used. On a Si-doped GaAs substrate [100], 0.5µm of Si-doped GaAs layer (n=1 x 10¹⁸cm⁻³) and 1.5pm of Si-doped GaAs layer (n=1 x 10¹⁷cm⁻³) were epitaxially grown, by using a reduced pressure (10 kPa (76 Torr)) MOVPE method. This wafer was drawn out of the MOVPE reaction-furnace, and left exposed in the atmosphere for 12 hours. Then the wafer was returned back to the reaction-furnace, and 0.5µm of Si-doped GaAs layer (n=1 x 10¹⁷cm⁻³) was regrown.

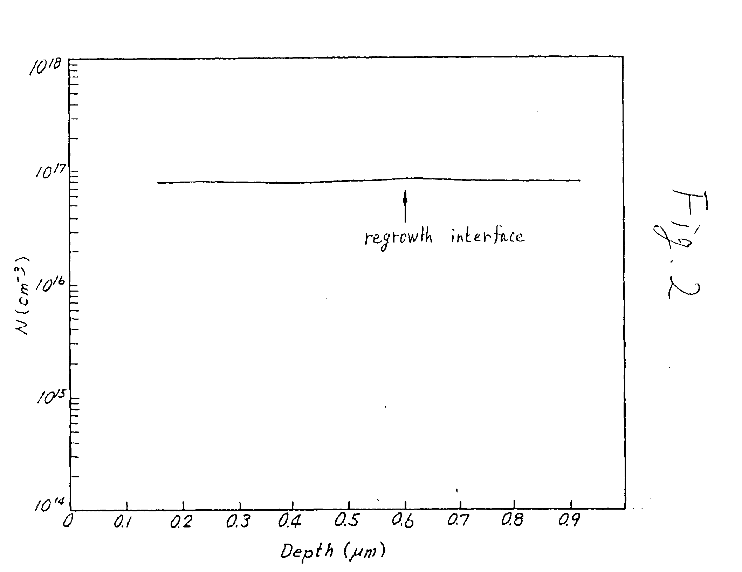

Before the regrowth, vapor phase etching of 0.3µm in thickness of the wafer surface was conducted with hydrogen chloride gas, in the MOVPE reaction-furnace. Si of the dopant entered the group III site, and in this case TMG was used as the group III metal organometallic gas together with the etching gas. The carrier-concentration distribution in the direction of depth was measured by the C-V method, for the regrown wafer in both cases where TMG was introduced (sample A) and TMG was not introduced (sample B) during the vapor etching, and the measurement result is shown in Fig. 1 and Fig. 2.

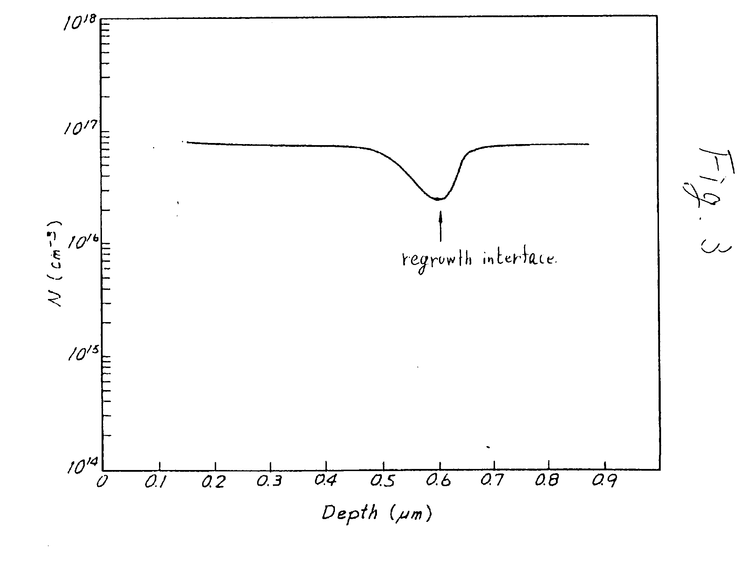

In the case of sample C, when the growth was effected as it was, without the vapor phase etching in the reaction-furnace prior to the regrowth, a big depletion of the carrier-concentration on the regrowth interface was noticed as shown in Fig. 3. This depletion part was a high resistive layer, which exerted such a big effect as to cause a thyristor phenomenon in the device performance. In the case where TMG was not introduced during the vapor phase etching, the carrier accumulation was noticed on the regrown interface. In contrast, in the case where TMG was introduced, a flat profile was obtained. The supplying of AsH₃ during this etching gave a decrease of etching rate, in dependence on the increase of the AsH₃ flow rate, but the accumulation of carrier-concentration was not dependent on the AsH₃ rate. The supplying of TMG gave no change of the etching rate, but caused the suppression of the carrier accumulation.

Also, a profile of the mobility in the depth direction was measured on the samples A and B. In the sample B, the mobility was greatly lowered nearby the carrier accumulation, but in the sample A, the mobility at the regrown interface was not noticed to be lowered. The planarization of carrier profile in the sample A was not due to the compensation of p-type impurities, and a high-quality regrown interface was found to be formed.

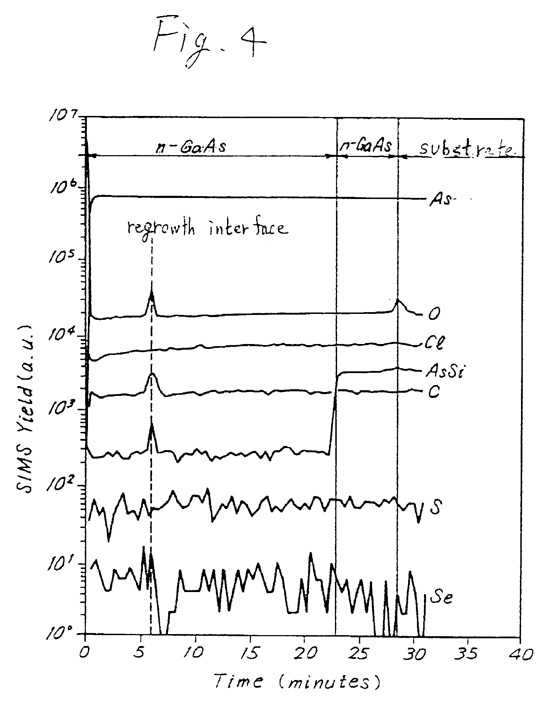

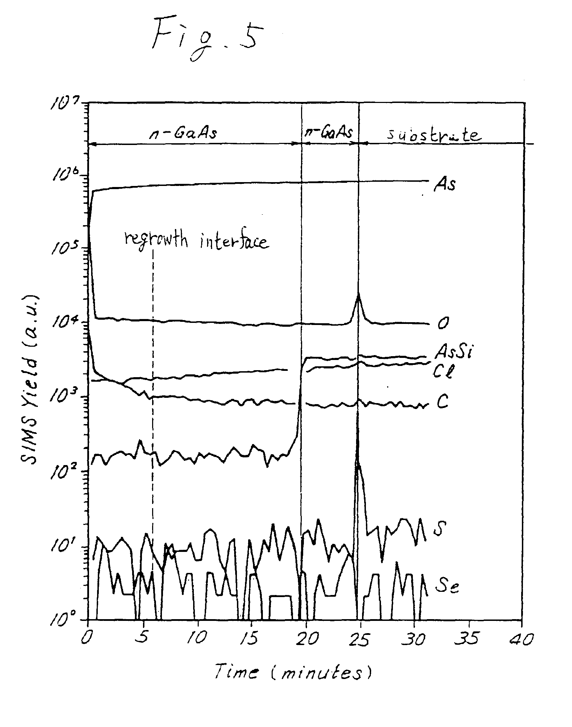

Further, the SIMS analysis of these samples was carried out. As shown in Fig. 4 and Fig. 5 the impurity peaks of oxygen, carbon, silicon and so on, which were noticed in the sample C regrown without a vapor phase etching, were not found. But it was recognized that a clean regrown interface was obtained by using a vapor phase etching, independently of supplying of TMG during the vapor phase etching.

It can be considered, from the facts mentioned above, that whether the carrier will be accumulated or not, in the case of the vapor phase etching, is related to the discrepancy of the surface stoichiometry by the vapor phase etching.

As stated above, in accordance with the present invention, the impurity pollution, the oxide film, the thermometamorphism layer and the like in the interface between a single crystal substrate and an epitaxial layer, and also in the regrown interface, which have been the problem up to this time, can be removed by effecting a vapor phase etching, introducing the hydrides containing group III organic metals gas and/or group V elements, or the group V organic metals gas, immediately before a compound semiconductor thin-film is grown. As a result, a high quality regrown interface having the clean surface and causing no accumulation or no depletion of the carriers can be obtained, thus making it possible to greatly improve performance as compared with a device prepared by a conventional method.

## Claims

1. A method of preparing a group III-V compound semiconductor thin film including
(a) effecting gas etching in a growth chamber, of a single crystal substrate surface and/or a single crystal thin-film surface on which said group III-V semiconductor thin film is to be grown, by introducing into the growth chamber, in a carrier gas, an etching gas and at least one additional compound selected from the following:-
(i) a group III metal organometallic gaseous compound;
(ii) a group V element organometallic gaseous compound;
(iii) a hydride of a group V element; and
(b) after step (a), carrying out vapor phase growth of said group III-V compound semiconductor thin film on the surface etched in step (a), in said growth chamber, with inclusion of a dopant to enter the group III site or the group V site;
wherein said additional compound in step (a) is a group III metal organometallic gaseous compound when the dopant is to enter the group III site in step (b), and is a hydride of a group V element or a group V element organometallic gaseous compound when the dopant is to enter the group V site in step (b).

2. A method according to claim 1 wherein the group III-V compound semiconductor thin-film is regrown or selectively grown on a mesa shape substrate or an epitaxial layer formed by gas etching in the growth chamber.

3. A method according to claim 1 or claim 2 wherein a halogen-containing gas is used as the vapor phase etching gas.

4. A method according to claim 3 wherein at least one of HCl, CCl₂F₂, AsCl₃ and Cl₂ is used as the vapor phase etching gas.

## Patentansprüche

1. Verfahren zur Herstellung eines III-V-Gruppen-Verbindungs-Halbleiterdünnfilms, umfassend:
(a) Durchführen von Gasätzen einer Einkriställsubstratoberfläche und/oder einer Einkristalldünnfilmoberfläche, auf der der III-V-Gruppen-Halbleiterdünnfilm gezüchtet werden soll, in einer Wachstumskammer durch Einleiten eines Trägergases, eines Ätzgases und zumindest einer aus den folgenden ausgewählten zusätzlichen Verbindung:
(i) eine gasförmige Metallorganyl-Verbindung eines Gruppe III-Metalls;
(ii) eine gasförmige Metallorganyl-Verbindung eines Gruppe V-Elements;
(iii) ein Hydrid eines Gruppe V-Elements;
in einem Trägergas in die Wachstumskammer; und
(b) das Durchführen von Dampfphasenwachstum des III-V-Gruppen-Verbindungs-Halbleiterdünnfilms auf der in Schritt (a) geätzten Oberfläche in der Wachstumskammer nach Schritt (a), unter Einschluß eines Dotiermittels, das die Gruppe III-Stelle oder die Gruppe V-Stelle einnimmt;
worin die zusätzliche Verbindung in Schritt (a) eine gasförmige Metallorganyl-Verbindung eines Gruppe III-Metalls ist, wenn das Dotiermittel in Schritt (b) die Gruppe III-Stelle einnehmen soll, und ein Hydrid eines Gruppe V-Elements oder eine gasförmige Metallorganyl-Verbindung eines Gruppe V-Elements ist, wenn das Dotiermittel in Schritt (b) die Gruppe V-Stelle einnehmen soll.

2. Verfahren nach Anspruch 1, worin der III-V-Gruppen-Verbindungs-Halbleiterdünnfilm auf einem mesaförmigen Substrat oder einer durch Gasätzen in der Wachstumskammer gebildeten Epitaxieschicht neu oder selektiv gezüchtet wird.

3. Verfahren nach Anspruch 1 oder 2, worin ein halogenhaltiges Gas als Dampfphasenätzgas verwendet wird.

4. Verfahren nach Anspruch 3, worin zumindest eines von HCI, CCl₂F₂, AsCl₃ und Cl₂ als Dampfphasenätzgas verwendet wird.

## Revendications

1. Méthode de préparation d'un film mince en un semi conducteur composé de groupe III-V consistant à
a) effectuer une attaque au gaz dans une chambre de croissance d'une surface d'un substrat monoprestal et/ou d'une surface en film mince non crystallin sur laquelle doit être tiré ledit film mince semi-conducteur du groupe III-V par introduction dans la chambre de croissance, dans un gaz porteur, d'un gaz d'attaque et d'au moins un composé additionnel sélectionné parmi ceux qui suivent :
i) un composé gazeux organométallique d'un métal du group III;
ii) un composé gazeux organométallique d'un élément du group V;
iii) un hybrure d'un élément du group V ; et (b) aprés l'étape (a), effectuée une croissance en phase de vapeur dudit film mince semi-conducteur composé du group III-V sur la surface attaquée à l'étape (a), dans ladite chambre de croissance avec inclusant d'un dopant pour entrer dans le site du group III ou le site du group V,
où ledit composé additionnel à l'étape (a) est un composé gazeux organométallique d'un métal du group III quand le dopant doit entrer dans le site du group III à l'étape (b) est un hybrure d'un élément du group V ou un composé gazeux organométallique d'un élément du group V quand le dopant doit entrer dans le site du group V à l'étape (b).

2. Méthode selon la revendication 1 où le film mince semi-conducteur composé du group III-V est à nouveau tiré ou selectivement tiré sur un substrat de forme mesa ou une couche epitaxié formée par attaque au gaz dans la chambre de croissance.

3. Méthode selon la revendication 1 ou la revendication 2 où un gaz contenant un allogène qui est utilisé en tant que gaz d'attaque en phase vapeur.

4. Méthode selon la revendication 3 ou au moins l'un de HCl, CCl₂ F₂, ASCl₃ , et Cl₂ , est utilisé en tant que gaz d'attaque en phase vapeur.
